# DEMANDE DE BREVET EUROPEEN

(11) **EP 2 784 817 A1**
(43) Date de publication de la demande: **01.10.2014**
(21) Numéro de dépôt: 14160606.1
(22) Date de dépôt: 18.03.2014
(51) Int. Cl.: H01L 27/092, H01L 29/786, H01L 27/118, H01L 27/12, H03K 19/00

(54) **Procédé de commande d'un circuit intégré**

(30) Priorité: 28.03.2013 FR 1352849
(71) Demandeur: Commissariat à l'Énergie Atomique et aux Énergies Alternatives, 75015 Paris (FR); STmicroelectronics SA, 92120 Montrouge (FR); STMicroelectronics (Crolles 2) SAS, 38920 Crolles (FR)
(72) Inventeur: Clerc, Sylvain, 38000 Grenoble (FR); Abouzeid, Fady, 38000 Grenoble (FR); Giraud, Bastien, 38340 Voreppe (FR); Noel, Jean-Philippe, 38330 Montbonnot Saint Martin (FR); Roche, Philippe, 38330 Biviers (FR); Thonnart, Yvain, 38100 Grenoble (FR)
(74) Mandataire: GIE Innovation Competence Group

(57) **Abrégé**

Procédé de commande d'un circuit intégré, comportant :
-la fourniture (100) d'un circuit intégré comprenant :
• une pluralité de cellules logiques, incluant chacune des premier et second transistors à effet de champ ;
• une cellule d'arbre d'horloge, incluant des troisième et quatrième transistors à effet de champ ;

-l'application (102) de première et seconde différences de potentiel électrique de grille arrière sur les, respectivement, premier et second transistors de mêmes cellules logiques ;
-l'application (104) d'une troisième différence de potentiel électrique de grille arrière sur le troisième transistor, présentant une valeur supérieure à la première différence de potentiel appliquée au même moment, ou
-l'application d'une quatrième différence de potentiel électrique de grille arrière sur le quatrième transistor, présentant une valeur supérieure à la seconde différence de potentiel appliquée au même moment.

## Description

L'invention concerne un procédé de commande d'un circuit intégré.

De façon connue, les circuits intégrés logiques synchrones nécessitent un signal d'horloge pour synchroniser le fonctionnement d'éléments logiques du circuit. Typiquement, ce signal d'horloge est distribué depuis un générateur de signal d'horloge vers des éléments du circuit, tels que des registres ou des bascules, par l'intermédiaire d'un arbre d'horloge (« clock tree » en langue anglaise). Cet arbre d'horloge est un réseau d'interconnexions électriques qui présente typiquement une structure arborescente, comportant un tronc commun, relié au générateur de signal d'horloge et se partageant en une multitude de rameaux, ou branches. Chacune de ces branches peut elle-même se partager en une pluralité de branches additionnelles.

Pour assurer un bon fonctionnement du circuit, et notamment éviter des violations de contraintes temporelles (« setup & hold time violations » en langue anglaise), cet arbre d'horloge doit être soigneusement configuré pour limiter l'apparition de différences de temps de propagation (« clock skew » en langue anglaise) du signal d'horloge. A cet effet, l'arbre d'horloge comprend typiquement des cellules d'arbre d'horloge, qui implémentent des fonctions optimisant la distribution du signal d'horloge, telles que l'ajout de délais (« buffer » en langue anglaise). Ainsi, chaque cellule d'arbre d'horloge est reliée à une branche de l'arbre d'horloge, et reçoit de cet arbre d'horloge un signal d'horloge entrant. Cette cellule d'arbre d'horloge est également adaptée pour fournir un signal d'horloge sortant, apte à être distribué aux éléments logiques du circuit. Dans le cas où la cellule d'arbre d'horloge présente un délai, le signal d'horloge sortant est identique au signal d'horloge entrant, sauf qu'il présente un retard égal à une valeur prédéfinie. Ces délais peuvent être adaptés lors d'étapes de conception du circuit intégré, pour équilibrer les branches de l'arbre d'horloge et contrôler l'apparition de différences de temps de propagation.

Typiquement, le circuit comprend également des cellules, dites logiques, contenant des transistors connectés de façon à former les éléments logiques du circuit. Des cellules de l'arbre d'horloge, situées aux extrémités des branches, sont électriquement reliées à des cellules logiques, pour leur transmettre le signal d'horloge sortant. Ces cellules de l'arbre d'horloge situées aux extrémités des branches sont appelées feuilles de l'arbre d'horloge (« clock tree leaf » en langue anglaise).

Dans cette description, le terme de « cellule standard » désigne une portion de circuit intégré correspondant à l'implémentation physique d'une fonction élémentaire. Ces cellules standard découlent de modèles typiquement regroupés dans une bibliothèque d'un logiciel de conception de circuits intégrés. Les cellules standard se différencient les unes des autres, par exemple, par les fonctions binaires réalisées, ou par leur sortance. On distingue, dans cette demande de brevet :
- des cellules standard (dites « cellules logiques ») fonctionnelles, utilisées pour la réalisation des fonctions logiques du circuit,
- des cellules standards d'arbre d'horloge (dites « cellules d'horloge »).

Les cellules d'horloge peuvent différer des cellules logiques par des caractéristiques particulières telles que l'équilibrage des délais montant et descendant, ou encore une sortance plus élevée. Les cellules d'arbre d'horloge habituellement utilisées sont structurellement similaires aux cellules logiques du circuit. Ces cellules feuilles de l'arbre d'horloge sont intégrées préférentiellement au plus près des cellules logiques, notamment pour réduire la longueur des liaisons électriques reliant ces cellules feuilles aux cellules logiques voisines.

Il est aujourd'hui souhaitable de réduire la consommation électrique des dispositifs à circuits intégrés, par exemple pour des applications en informatique nomade. Il est ainsi nécessaire de pouvoir faire fonctionner des circuits intégrés dans des modes spécifiques à basse consommation d'énergie, dans lesquels la tension d'alimentation électrique est réduite (« ultra-low voltage » en langue anglaise).

Cependant, la réduction de la tension d'alimentation électrique d'un tel circuit peut entraîner une dégradation de la performance de l'arbre d'horloge. Cette dégradation provient, par exemple, d'une plus grande sensibilité de l'arbre d'horloge à des variabilités du processus de fabrication des transistors, lorsque le circuit est alimenté électriquement avec une tension d'alimentation de valeur réduite. Cette plus grande sensibilité conduit à une hausse des violations de contraintes temporelles. Il est alors nécessaire de modifier l'arbre d'horloge en y rajoutant de multiples éléments, tels que des délais, ce qui complique la conception et la fabrication du circuit.

De l'état de la technique est également connu des documents suivants :
- WO 2012/160071 (COMMISARIAT ENERGIE ATOMIQUE) ;
- JP 2009044220 A (HITACHI LTD) ;
- JP 2009070939 (HITACHI LTD) ;
- US 2001/052632 A1 (KAMEYAMAATUSUSHI) ;
- US 5610533 A (ARIMOTO KAZUTAMI) ;
- JP 2005353274 A (RENESAS TECH CORP) ;
- JP 2006066062 A (RENESAS TECH CORP) ;
- WO 98/54419 (INTEL CORP) ;
- US 2012/146148 A1 (IWAMATSU TOSHIAKI) ;
- « Multi-Vt UTBB FDSOI device architectures for low-power CMOS circuit » J.-P. Noël et al., IEEE Transactions on Electron Devices, vol. 58 p. 2473-2482, 1er août 2011 ;
- « UT2B-FDSOI device architecture dedicated to low power design techniques », J.-P. Noël et al., 2010 Proceedings of The European Solid-State Device Research Conference, IEEE, p. 2106213, 14 septembre 2010.

Il existe donc un besoin pour un circuit intégré comprenant une cellule d'arbre d'horloge dont les performances présentent une meilleure robustesse lorsque le circuit intégré est alimenté avec une tension électrique de valeur réduite.

L'invention porte ainsi sur un procédé de commande d'un circuit intégré conforme à la revendication 1.

L'application de la troisième et/ou de la quatrième différence de potentiel de grille arrière permet de moduler la tension de seuil des, respectivement, troisième et/ou quatrième transistors. Plus précisément, lorsque le circuit intégré est alimenté par une tension électrique réduite, on choisit d'appliquer une différence de potentiel de grille arrière choisie pour abaisser cette tension de seuil par rapport à la tension de seuil des transistors des cellules logiques. Il en résulte une augmentation de la sortance de la cellule d'horloge. Cette augmentation vient compenser, pour cette cellule d'horloge, la diminution de la tension d'alimentation du circuit et l'augmentation du temps de transition de sa sortie qui en découle. La cellule d'horloge, bien qu'alimentée avec une tension réduite, préserve sa sortance et le temps de transition de sa sortie, ce qui réduit la dégradation de performance des cellules d'horloge. Ainsi, les performances électriques de l'arbre d'horloge sont améliorées.

Les modes de réalisation de l'invention peuvent comporter une ou plusieurs des caractéristiques des revendications dépendantes 2 à 10.

Ces modes de réalisation présentent en outre les avantages suivants :
- l'utilisation des premier et second caissons profondément enterrés permet, en technologie « bulk », l'application simultanée des troisième et quatrième différences de potentiel ;
- l'utilisation de transistors de technologie FDSOI permet d'appliquer des différences de potentiel de grille arrière plus élevées qu'en technologie bulk, ce qui permet de disposer d'un contrôle accru du comportement de la cellule d'horloge ;
- l'application de seule l'une ou l'autre des troisième ou quatrième différences de potentiel de grille arrière permet de ne modifier que les propriétés du transistor pMOS ou nMOS de la cellule d'horloge, et donc d'agir seulement sur des fronts montants ou descendants du signal d'horloge.

L'invention sera mieux comprise à la lecture de la description qui va suivre, donnée uniquement à titre d'exemple non limitatif et faite en se référant aux dessins sur lesquels :
- la figure 1 est une illustration schématique, selon une vue en coupe, d'une portion d'un circuit intégré comportant une cellule d'horloge et une cellule logique ;
- la figure 2 est un organigramme d'un procédé de commande de la cellule d'horloge de la figure 1 ;
- les figures 3A et 3B sont des schémas électriques illustrant des potentiels électriques appliqués sur des transistors des cellules, respectivement, logique et d'horloge, du circuit de la figure 1 ;
- les figures 4 à 8 sont des illustrations schématiques, selon une vue en coupe, d'autres modes de réalisation des cellules logique et d'horloge de la figure 1.

Dans ces figures, les mêmes références sont utilisées pour désigner les mêmes éléments.

Dans la suite de cette description, les caractéristiques et fonctions bien connues de l'homme du métier ne sont pas décrites en détails.

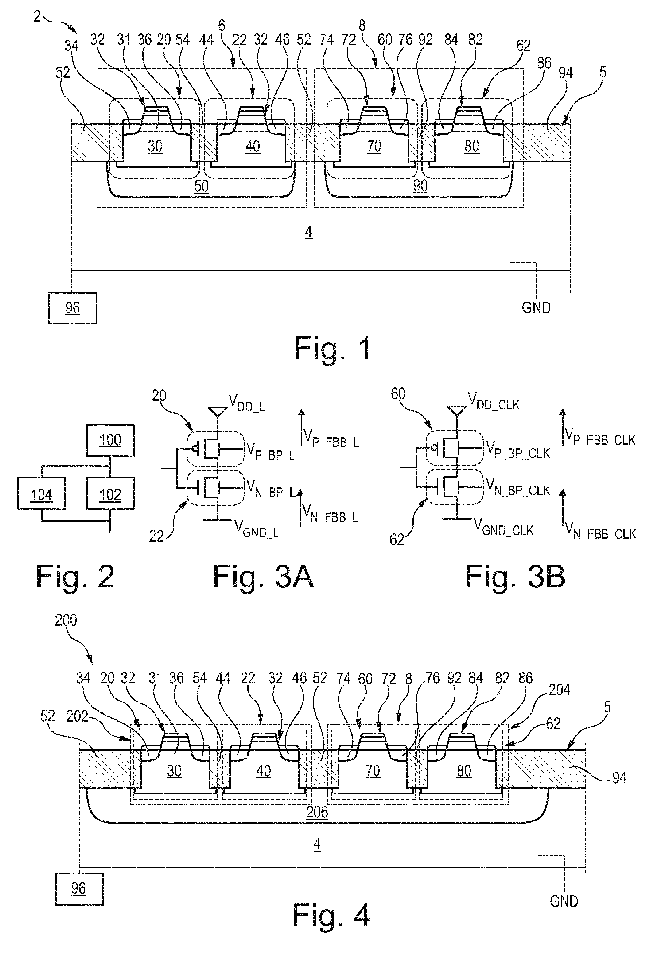

La figure 1 représente, de manière simplifiée, une partie d'un circuit intégré 2. Ce circuit 2 comporte :
- un substrat semi-conducteur 4 ;
- une cellule logique 6, et
- une cellule d'horloge 8.

Le substrat 4 s'étend essentiellement dans un plan dit « plan du substrat », ici horizontal. Ce plan du substrat forme une partie inférieure du circuit 2. Ce substrat 4 présente ici un dopage de type p avec une concentration de dopants inférieure ou égale à 10¹⁶ cm⁻³ ou à 3*10¹⁵ cm⁻³. Ce substrat 4 est ici relié électriquement à une masse électrique GND du circuit 2. Ce circuit 2 présente ici une face supérieure 5 horizontale.

Le circuit 2 peut comporter une pluralité de cellules logiques, par exemple identiques, qui reçoivent un signal d'horloge fourni par une même cellule d'arbre d'horloge. Cependant, pour simplifier, sur la figure 1 et les figures suivantes, seule une cellule logique 6 et une cellule d'arbre d'horloge 8 sont représentées.

La cellule 6 comporte des transistors 20, 22 à effet de champ et de type métal-oxyde-semi-conducteur (MOS). Ces transistors 20, 22 sont réalisés suivant la technologie « bulk ».

Le transistor 20, formé dans et sur un caisson semi-conducteur 30 (« well » en langue anglaise) comporte ainsi :
- un empilement de grille 32, disposé au-dessus et à l'aplomb du caisson 30, cet empilement 32 comportant une grille ;
- une source 34 et un drain 36, disposés au-dessus du ou dans le caisson 30 et de part et d'autre de l'empilement 32.

Le caisson 30 se situe au-dessus du substrat 4 et s'étend essentiellement parallèlement au plan du substrat. Ce caisson 30 est par exemple formé par implantation de dopants, depuis la face supérieure 5 du circuit 2. Dans cet exemple, le transistor 20 est un transistor pMOS. Le caisson 30 présente un dopage de type n. La source 34 et le drain 36 présentent des dopages de type p.

Dans un transistor à effet de champ, l'application de potentiels électriques adéquats sur la source, la grille et le drain du transistor conduit à la formation d'un canal de conduction électrique dans une région de canal 31, dans le caisson 30, entre la source 34 et le drain 36. Le caisson 30 est apte à être polarisé électriquement afin de modifier des propriétés de ce canal comme, notamment, la tension de seuil du transistor (« threshold voltage » en langue anglaise). Le caisson 30 comporte donc une prise de contact (non illustrée en détail sur la figure 1) permettant d'appliquer ce potentiel électrique. Ce caisson 30 forme donc ici une grille arrière (« back gate » en langue anglaise) du transistor 20. Chacune des sources 34 et drain 36 comporte une prise de contact électrique, apte à permettre l'application d'un potentiel électrique sur, respectivement, la source 34 et le drain 36.

Le transistor 22 est identique au transistor 20, sauf que :
- le caisson 30 est remplacé par un caisson 40 de dopage opposé ;
- la source 34 et le drain 36 sont remplacés, respectivement, par une source 44 et un drain 46 de dopages opposés.

Ainsi, le transistor 22 est un transistor nMOS. Le caisson 40 présente un dopage de type p. La source 44 et le drain 46 présentent tous deux un dopage de type n.

Mis à part ces différences, tout ce qui a été dit en référence au transistor 20 s'applique au transistor 22.

La cellule 6 comporte en outre un caisson profondément enterré 50 (« deep well » en langue anglaise), situé sous et à l'aplomb des caissons 30 et 40, en contact direct avec ces caissons 30 et 40, pour isoler électriquement ces caissons 30 et 40 du substrat 4. Ce caisson 50 présente ici un dopage de type n. Ainsi, ce caisson 50 est ici en contact électrique avec le caisson 30, mais forme avec le caisson 40 une jonction p-n apte à être polarisée en sens inverse. Dans cette description, l'épaisseur et la profondeur sont définies par rapport à la direction verticale, perpendiculaire à la face 5. La profondeur est définie par rapport à un plan de référence horizontal, passant, par exemple, par la face 5.

Dans cette description, deux éléments sont dits être en contact direct s'ils sont immédiatement en contact physique l'un avec l'autre et si aucun autre élément de nature différente n'est interposé entre ces deux éléments.

Ici, la cellule comporte des tranchées d'isolation 52 et 54. La tranchée 52 isole les canaux de conduction des transistors de la cellule 6 des canaux de conduction des autres transistors des cellules adjacentes. La tranchée 54 isole l'un de l'autre les canaux de conduction des transistors 20 et 22. Ces tranchées 52 et 54 sont ici verticales. La tranchée 52 entoure la cellule 6 sur tout son pourtour extérieur. La tranchée 54 s'étend entre les transistors 20 et 22. Ces tranchées 52 et 54 sont réalisées dans un matériau électriquement isolant. Par matériau électriquement isolant, on désigne ici un matériau dont la résistivité électrique, à une température de 20°C, est supérieure ou égale à 10⁵Ω.m ou à 10⁶Ω.m. Par exemple, ces tranchées 52 et 54 sont réalisées en oxyde de silicium (SiO₂).

La cellule 8 est apte à fournir un signal d'horloge aux transistors de la cellule 6. Ici, le signal d'horloge est un signal périodique présentant une succession alternée de fronts montants et descendants. Cette cellule 8 appartient à un réseau de distribution d'un signal d'horloge, dit arbre d'horloge, du circuit 2. La cellule 8 est ici contiguë à la cellule 6. La cellule 8 comporte des transistors 60 et 62. Ces transistors 60 et 62 sont ici identiques, respectivement, aux transistors 20 et 22. Tout ce qui est décrit en référence aux transistors 20 et 22 s'applique donc aux transistors 60 et 62. Cependant, ici :
- les caissons correspondant aux caissons 30 et 40 portent, respectivement, les références 70 et 80 ;
- les empilements de grille correspondant aux empilements 32 et 42 portent, respectivement, les références 72 et 82 ;
- les sources correspondant aux sources 34 et 44 portent, respectivement, les références 74 et 84 ;
- les drains correspondant aux drains 36 et 46 portent, respectivement, les références, 76 et 86.

Dans cette description, deux cellules dites « identiques » peuvent présenter des différences géométriques, par exemple rendues nécessaires par des étapes de conception du circuit, pour adapter ces cellules aux connexions électriques avec d'autres cellules du circuit, contiguës à ces cellules. Par exemple, ces différences sont rendues nécessaires au cours d'étapes de placement lors de la génération automatique d'une topologie du circuit. Il en va de même pour des transistors dits « identiques ».

La cellule 8 comporte en outre un caisson profondément enterré 90, par exemple identique au caisson 50, sauf qu'il est situé directement sous les caissons 70 et 80. Ces caissons 50 et 90 sont distincts et séparés l'un de l'autre, de façon à ne pas être en contact électrique direct l'un avec l'autre. Ici, ces caissons 50 et 90 sont séparés l'un de l'autre par une portion du substrat 4, qui présente un dopage de type opposé à celui des caissons 50 et 90, pour empêcher une conduction électrique directe entre ces deux caissons 50 et 90. Ici, ces caissons sont séparés par au moins une jonction p-n apte à être polarisée en sens inverse lors du fonctionnement du circuit. De fait, les caissons 30, 40 sont isolés électriquement des caissons 70, 80. Ainsi, des potentiels électriques distincts peuvent être appliqués sur les caissons 30 et 70. Il en va de même pour les caissons 40 et 80.

En outre, ce caisson 90 est électriquement isolé de la grille arrière du transistor 20 par l'intermédiaire d'une jonction p-n, apte à être polarisée en sens inverse lors du fonctionnement du circuit intégré. Cette jonction p-n est ici formée par le caisson 50 en contact direct avec le substrat 4.

Avantageusement, la cellule 8 comporte des tranchées d'isolation 92 et 94 respectivement identiques aux tranchées 52 et 54. Ici, les cellules 6 et 8 étant accolées, une portion de la tranchée 52 est commune avec la tranchée 94. Sur la figure 1, la référence 52 désigne cette partie commune.

Le circuit 2 comporte en outre un dispositif de polarisation électrique 96, apte à appliquer des potentiels électriques sur les caissons 30, 40, 70, 80, ainsi que sur les électrodes des transistors 20, 22, 60, 62. Par électrodes d'un transistor, on désigne le drain, la source et la grille de ce transistor. À cet effet, ce dispositif 96 comporte un réseau d'interconnexions électriques, connectés électriquement à ces caissons et aux électrodes de ces transistors. Pour simplifier la figure 1, ce réseau d'interconnexions n'est pas représenté.

Ce dispositif 96 est notamment apte à appliquer des différences de potentiels de grille arrière (« back biasing » en langue anglaise) distinctes sur chacun de ces transistors. On définit la différence de potentiel de grille arrière d'un transistor comme étant :
- la valeur du potentiel électrique appliqué sur la source moins la valeur du potentiel appliqué sur la grille arrière de ce transistor, lorsque ce transistor est un pMOS ;
- la valeur du potentiel électrique appliqué sur la grille arrière moins la valeur du potentiel appliqué sur la source de ce transistor, lorsque ce transistor est un nMOS.

Un procédé de commande du circuit 2 va maintenant être décrit, en référence à l'organigramme de la figure 2 et à l'aide des figures 1, 3A et 3B.

Lors d'une étape 100, le circuit 2 est fourni. Ce circuit est, par exemple, mis en marche et alimenté par une source de tension électrique, par exemple à une tension réduite.

Puis, lors d'une étape 102, des potentiels électriques sont appliqués sur les transistors de la cellule 6. Notamment, le dispositif 96 applique :
- des potentiels V_{DD_L} et V_{GND_L} sur les sources, respectivement, 34 et 44 ;
- des potentiels V_{P_BP_L} et V_{N_BP_L} sur les caissons, respectivement, 30 et 40.

Les valeurs de ces potentiels sont choisies de façon à ce que des différences de potentiel de grille arrière V_{P_FBB_L} = V_{DD_L} - V_{P_BP_L} , et V_{N_FBB_L} = V_{N_BP_L} - V_{GND_L}, respectivement, des transistors 20 et 22, présentent une valeur positive (« forward back biasing » en langue anglaise). Ces potentiels électriques sont récapitulés dans la figure 3A. Ici, les transistors 20 et 22 sont connectés entre eux pour former un inverseur logique de technologie CMOS (« Complementary Metal Oxide Semiconductor » en langue anglaise). Ces valeurs sont également choisies pour éviter de polariser en sens direct des jonctions p-n formées par des caissons, entre eux ou avec le substrat, ce qui aurait pour effet de causer des courants de fuite dans le circuit 2. Par exemple, ici :
- V_{DD_L} = 1,2 V;
- V_{GND_L} = 0 V ;
- V_{P_BP_L} = 1 V ;
- V_{N_BP_L} = 0,3 V.

En parallèle, lors d'une étape 104, des potentiels électriques sont appliqués sur les transistors de la cellule 8. Notamment, le dispositif 96 applique :
- des potentiels V_{DD_CLK} et V_{GND_CLK} sur les sources, respectivement, 74 et 84 ;
- des potentiels V_{P_BP_CLK} et V_{N_BP_CLK} sur les caissons, respectivement, 70 et 80.

Typiquement, les potentiels V_{DD_CLK} et V_{GND_CLK} sont égaux, respectivement, aux potentiels V_{DD_L} et V_{GND_L}.

Les valeurs de ces potentiels V_{P_BP_CLK} et V_{N_BP_CLK} sont choisies de façon à ce que des différences de potentiel de grille arrière V_{P_FBB_CLK} = V_{DD_CLK} - V_{P_BP_CLK}, et V_{N_FBB_CLK} = V_{N_BP_CLK} - V_{GND_CLK}, respectivement, des transistors 60 et 62, présentent ici une valeur positive (« forward back biasing » en langue anglaise). Ces potentiels électriques sont récapitulés dans la figure 3B. Ici, les transistors 60 et 62 sont connectés entre eux pour former un inverseur logique de technologie CMOS.

Dans cet exemple, le dispositif 96 applique des potentiels V_{P_BP_CLK} et V_{N_BP_CLK} tels que au moins l'une des deux relations suivantes soit vérifiée :
- V_{P_FBB_CLK} présente une valeur strictement supérieure à V_{P_FBB_L}, et
- V_{N_FBB_CLK} présente une valeur strictement supérieure à V_{N_FBB_L}.

Par exemple, V_{P_FBB_CLK} est supérieur à 1,01*V_{P_FBB_L} ou à 1,05*V_{P_BB_L} et, de préférence, inférieure à 1,3* V_{P_FBB_L} ou à 1,5* V_{P_FBB_L}. De même, V_{N_FBB_CLK} est supérieur à 1,01* V_{N_FBB_L} ou à 1,05*V_{N_FBB_L} et, de préférence, supérieur à 1,3*V_{N_FBB_L} ou à 1,5* V_{N_FBB_L}. Dans cet exemple, puisque ces deux relations peuvent être simultanément vérifiées, alors V_{P_BP_CLK} est ici inférieur à 1V et V_{N_BP_CLK} est ici supérieur à 0,3V ou à 0,4 V.

Les transistors de la cellule 8 présentent ainsi une différence de potentiel de grille arrière distincte de celle appliquée sur les transistors de la cellule 6. Les valeurs choisies permettent notamment d'abaisser la tension de seuil des transistors de la cellule 8 par rapport à la tension de seuil des transistors de la cellule 6. Lorsque le circuit 2 fonctionne dans un mode de basse consommation électrique et que la tension d'alimentation nominale des transistors est réduite, l'abaissement de la tension de seuil des transistors 60 et 62 permet d'augmenter leur sortance électrique et donc diminuer le temps de transition du signal d'horloge en sortie de cette cellule, pour compenser la diminution de la tension d'alimentation. Cela améliore le fonctionnement des transistors 60 et 62, et donc améliore la fiabilité et les performances de l'arbre d'horloge dans son ensemble.

Cette modulation de tension de seuil est en outre modifiable au cours de l'utilisation du circuit 2 contrairement à des circuits dans lesquels ces tensions de seuil sont fixées lors de la fabrication du circuit, par exemple en choisissant des propriétés spécifiques de dopage des caissons des transistors de la cellule 8.

La figure 4 représente un circuit 200 apte à remplacer le circuit 2. Ce circuit 200 est identique au circuit 2, sauf que les cellules 6 et 8 sont remplacées, respectivement, par des cellules 202 et 204. Les cellules 202 et 204 sont identiques, respectivement, aux cellules 6 et 8, sauf que les caissons 50 et 90 sont remplacés par un unique caisson profondément enterré 206. Ce caisson 206 s'étend dans le plan du substrat, sous et en contact direct avec les caissons 30, 40, 70 et 80. Ce caisson 206 présente ici un dopage de type n, par exemple le même que celui des caissons 50 et 90.

Ainsi, les caissons 30 et 70, tous deux dopés n, sont en contact électrique l'un avec l'autre par l'intermédiaire de ce caisson 206. Les caissons 40 et 80, tous deux dopés p, sont isolés électriquement l'un de l'autre et également isolés du substrat 4 par le caisson 206. De fait, il est toujours possible d'appliquer des potentiels distincts V_{N_BP_L} et V_{N_BP_CLK} sur, respectivement, ces caissons 40 et 80. En revanche, les caissons 30 et 70, tous deux dopés n, sont polarisés à un même potentiel électrique par l'intermédiaire de ce caisson 206, et donc V_{P_BP_L} = V_{P_BP_CLK}.

Dans ce cas, pour ce circuit 200, lors de l'étape 104, seule la relation V_{N_FBB_CLK} > V_{N_FBB_L} est vérifiée. Le transistor 62 présente une tension de seuil réduite, mais ce n'est pas le cas du transistor 60. Les performances de la cellule 204 ne sont que partiellement améliorées. En effet, par rapport à l'exemple décrit en référence au circuit 2, les transistors pMOS de la cellule 204 ne peuvent pas se voir appliquer de potentiel de grille arrière distinct de celui appliqué sur les transistors pMOS de la cellule 202. Cependant, cette configuration permet néanmoins de modifier les performances du transistor nMOS de la cellule 204. Avec le circuit inverseur formé par les transistors de la cellule 8, la modification des performances des transistors nMOS de la cellule 204 permet d'accélérer les fronts descendants du signal d'horloge sortant de la cellule 8 en réponse à un signal d'horloge entrant et ainsi de limiter l'apparition de différences de temps de propagation dans le signal d'horloge. La traversée, par le signal d'horloge entrant, de plusieurs cellules d'horloge, identiques à la cellule 8 et connectées électriquement en série accélère les deux fronts du signal d'horloge sortant.

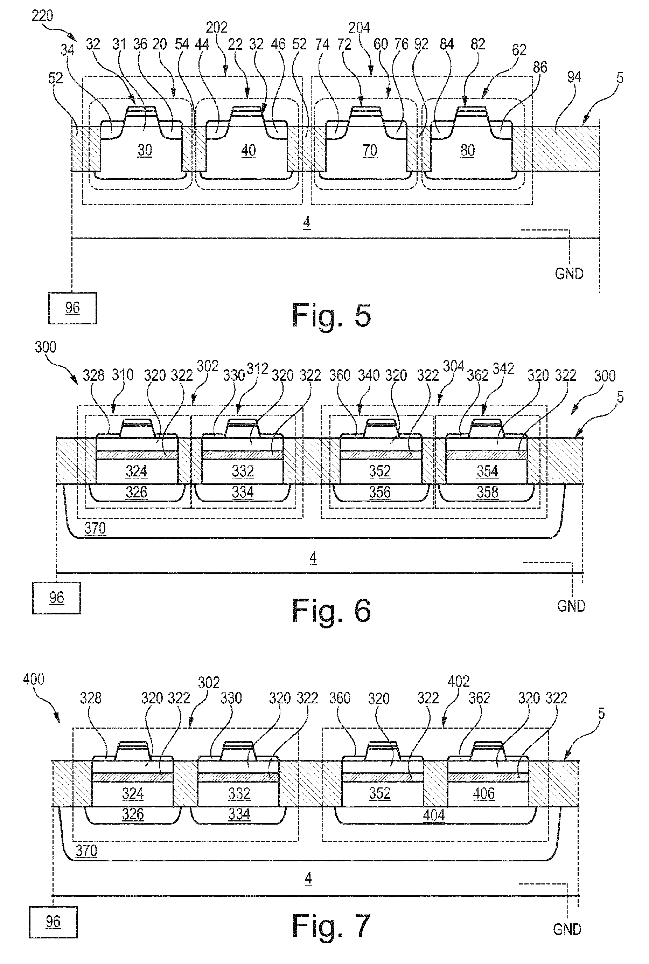

La figure 5 représente un circuit 220, apte à remplacer le circuit 4 ou 200. Ce circuit 220 est identique au circuit 200, sauf que le caisson 206 est omis. Dans ce cas, les caissons 30, 40, 70 et 80 sont tous en contact direct avec le substrat 4. En particulier, les caissons 40 et 80, tous deux dopés p, sont en contact électrique l'un avec l'autre par l'intermédiaire du substrat 4. En revanche, les caissons 30 et 70, dopés n, sont électriquement isolés l'un de l'autre par le substrat 4, dopé p. De fait, il est toujours possible d'appliquer des potentiels distincts V_{P_BP_L} et V_{P_BP_CLK} sur, respectivement, ces caissons 40 et 80. En revanche, les caissons 30 et 70 sont polarisés à un même potentiel électrique, et donc V_{N_BP_L} = V_{N_BP_CLK}. Ce même potentiel électrique est ici égal à zéro, puisque le substrat 4 est ici connecté électriquement à la masse GND du circuit.

Dans ce cas, pour ce circuit 200, lors de l'étape 104, seule la relation V_{P_FBB_CLK} > V_{P_FBB_L} est vérifiée. Le transistor 60 présente une tension de seuil réduite, mais ce n'est pas le cas du transistor 62. Les performances de la cellule 204 ne sont que partiellement améliorées. De manière analogue à ce qui a été décrit en référence au circuit 200, le circuit inverseur formé par les transistors de la cellule 204 permet, en modifiant les performances des transistors pMOS de la cellule 204, d'accélérer les fronts montants du signal d'horloge entrant et ainsi de limiter l'apparition de différences de temps de propagation dans le signal d'horloge.

La figure 6 décrit un circuit 300, apte à remplacer le circuit 4. Ce circuit est identique au circuit 4, sauf que les cellules 6 et 8 sont remplacées, respectivement, par des cellules 302 et 304. Ces cellules 302 et 304 sont identiques, respectivement, aux cellules 6 et 8, sauf que les transistors 20, 22, 60 et 62 sont remplacés par des transistors MOS de technologie FDSOI (pour « Fully Depleted Silicon On Insulator » en langue anglaise).

La cellule 302 comporte ainsi des transistors 310 et 312. Le transistor 310 comporte notamment :
- une couche semi-conductrice 320, dite couche active ;
- un plan de masse semi-conducteur 324, situé sous la couche 310 ;
- une couche enterrée 322 de matériau électriquement isolant, interposée entre la couche 320 et le plan de masse 324 pour isoler électriquement la couche 320 du plan de masse 324 ;
- un caisson semi-conducteur 326, situé sous et à l'aplomb du plan de masse 324.

La couche 320 forme un canal entre une source 328 et un drain du transistor. En technologie FDSOI, cette couche 320 est dans un état déserté (« depleted » en langue anglaise) et présente un niveau de dopage très faible, typiquement inférieur ou égal à 10¹⁵ cm⁻³. Cette couche 320 présente une épaisseur inférieure ou égale à 50nm.

La couche 322 est ici de type ultra-fine, dite UTBOX (pour « Ultra-Thin Buried OXide layer » en langue anglaise) et présente une épaisseur inférieure à 40nm et, de préférence, inférieure ou égale à 25nm.

Le plan de masse 324 (« back plane » en langue anglaise) forme ici une grille arrière du transistor 20. Ce plan de masse 324 est situé directement et uniquement sur le caisson 326, de sorte à ce qu'un potentiel électrique puisse y être appliqué par l'intermédiaire du caisson 326. Typiquement, en technologie FDSOI, pour le noeud technologique 28nm, l'application d'un potentiel électrique d'un plan de masse est assurée par l'intermédiaire d'un caisson semi-conducteur, en contact direct avec le plan de masse et présentant un dopage de même type que ce plan de masse. À cet effet, le plan de masse 324 s'étend horizontalement et est disposé immédiatement au-dessus du caisson 326, en contact direct avec ce caisson 326, de manière à être situé à l'aplomb de la couche 320. Dans cet exemple, le plan de masse 324 présente un dopage de même type que le dopage du caisson 326. La concentration de dopants du plan de masse 326 est ici comprise entre 10¹⁸ et 10²⁰ cm⁻³. Ce plan de masse 324 présente ici une épaisseur comprise entre 50nm et 300nm et, de préférence, entre 70nm et 200nm. Le plan de masse 324 et le caisson 326 sont ici fabriqués à partir d'un même matériau semi-conducteur, par application d'étapes distinctes d'implantation ionique.

Dans cet exemple, le transistor 310 est de type pMOS. Par exemple, le plan de masse 324 et le caisson 326 présentent un dopage de type p.

Le transistor 312 est identique au transistor 310, sauf que :
- le transistor 312 est de type nMOS ;
- la source correspondant à la source 328 porte la référence 330 ;
- le plan de masse correspondant au plan de masse 324 et le caisson correspondant au caisson 326 sont remplacés, respectivement, par un plan de masse 332 et un caisson 334 dont ils ne diffèrent que par le type de dopage. Ce plan de masse 332 et ce caisson 334 présentent ici un dopage de type n.

La cellule 304 joue le même rôle que la cellule 8. La cellule 304 comporte deux transistors 340 et 342, respectivement identiques aux transistors 310 et 312. Tout ce qui est décrit en référence aux transistors 310 et 312 s'applique donc aux transistors 340 et 342. Cependant, ici :
- les plans de masse correspondant aux plans de masse 324 et 332 portent, respectivement, les références 352 et 354 ;
- les caissons correspondant aux caissons 326 et 334 portent, respectivement, les références 356 et 358 ;
- les sources correspondant aux sources 328 et 330 portent, respectivement, les références 360 et 362.

Le circuit 300 comporte en outre un caisson profondément enterré 370. Ce caisson 370 s'étend sous et en contact direct avec les caissons 326, 334, 356 et 358 pour isoler électriquement ces caissons du substrat 4. Ce caisson 370 est, par exemple, identique au caisson 206.

Lors des étapes 102 et 104, le dispositif 96 applique :
- les potentiels V_{DD_L} et V_{GND_L} sur les sources, respectivement, 328 et 330 ;
- les potentiels V_{P_BP_L} et V_{N_BP_L} sur les caissons, respectivement, 326 et 334 ;
- les potentiels V_{DD_CLK} et V_{GND_CLK} sur les sources, respectivement, 360 et 362 ;
- des potentiels V_{P_BP_CLK} et V_{N_BP_CLK} sur les caissons, respectivement, 356 et 358.

Ces valeurs de potentiels électriques sont ici choisis pour respecter la relation V_{P_FBB_CLK} > V_{P_FBB_L}. Par rapport au cas décrit en référence au circuit 2, ces valeurs de potentiel sont également choisies pour éviter de polariser en sens direct des jonctions p-n formées par des caissons, entre eux ou avec le substrat, ce qui aurait pour effet de causer des courants de fuite dans le circuit 300.

Les caissons 326 et 356, tous deux dopés p, sont isolés électriquement l'un de l'autre et également isolés du substrat 4 par le caisson 370. De fait, il est toujours possible d'appliquer des potentiels distincts V_{P_BP_L} et V_{P_BP_CLK} sur, respectivement, ces caissons 326 et 356. En revanche, les caissons 334 et 358 sont polarisés à un même potentiel électrique, et donc V_{N_BP_L} = V_{N_BP_CLK}.

L'utilisation de transistors de technologie FDSOI permet d'appliquer des valeurs plus importantes de différence de potentiels de grille arrière par rapport aux transistors de technologie bulk, et donc de limiter encore plus l'apparition de différences de temps de propagation du signal d'horloge. Par exemple, la valeur maximale de la différence de potentiels de grille arrière des transistors FDSOI est 1,5 fois ou 2 fois supérieure à la valeur maximale de la différence de potentiels de grille arrière des transistors bulk.

La figure 7 représente un circuit 400, apte à être utilisé en lieu et place du circuit 300. Ce circuit 400 ne diffère du circuit 300 que par le fait que la cellule 304 est remplacée par une cellule 402. Cette cellule est identique à la cellule 304, sauf que :
- les caissons 356 et 358 sont remplacés par un unique caisson 404, dopé p ;
- le plan de masse 354 est remplacé par un plan de masse 406 présentant un dopage de type p.

Ainsi, les plans de masse 352 et 406 sont isolés du substrat 4 par l'intermédiaire de ce caisson 406, ce qui permet de moduler la tension de seuil des transistors 340 et 342 simultanément.

Lors de l'étape 104, le dispositif 96 applique un même potentiel électrique sur le caisson 406, et donc sur les plans de masse 352 et 406.

De nombreux autres modes de réalisation sont possibles.

Le substrat 4 peut présenter un dopage n. Dans ce cas, les dopages respectifs des caissons profondément enterrés peuvent être choisis différemment.

La cellule 6 peut comporter plus de deux transistors pMOS et/ou nMOS identiques, respectivement, aux transistors 20, 22. Dans ce cas, ces transistors sont aptes à se voir appliquer une différence de potentiel de grille arrière de la même manière que, respectivement, les transistors 20, 22. Il en va de même pour la cellule 8.

Le procédé, et en particulier l'étape 104, n'est pas forcément appliqué en permanence pendant toute la durée de fonctionnement du circuit 2. Par exemple, l'étape 104 n'est pas appliquée lorsque le circuit 2 est en veille. Lorsque l'étape 104 n'est pas appliquée, des différences de potentiel de grile arrière V_{P_FBB_CLK} et V_{N_FBB_CLK} peuvent tout de même être appliquées, mais ne satisfaisant alors pas les relations V_{N_FBB_CLK} > V_{N_FBB_L} et V_{P_FBB_CLK} > V_{P_FBB_L}. L'étape 104 peut n'être également uniquement appliquée que sur des cellules appartenant à une portion du circuit 2.

Les circuits 300 et 400 peuvent être réalisés suivant une technologie de fabrication FDSOI autre que la technologie 28nm, comme par exemple la technologie FDSOI 14nm. Dans ce cas, les plans de masse peuvent être électriquement polarisés directement, sans passer par l'intermédiaire des caissons semi-conducteurs. Les caissons 326, 334, 356, 358 et 404 peuvent donc être omis ou présenter des dopages de types différents de celui du plan de masse sous lequel ils sont respectivement situés.

Le caisson profondément enterré 370 peut être remplacé par deux caissons profondément enterrés, respectivement identiques aux caissons 50 et 90 et jouant le même rôle que ces caissons 50 et 90 pour isoler électriquement du substrat, respectivement, les caissons 326, 334 et les caissons 356 et 358.

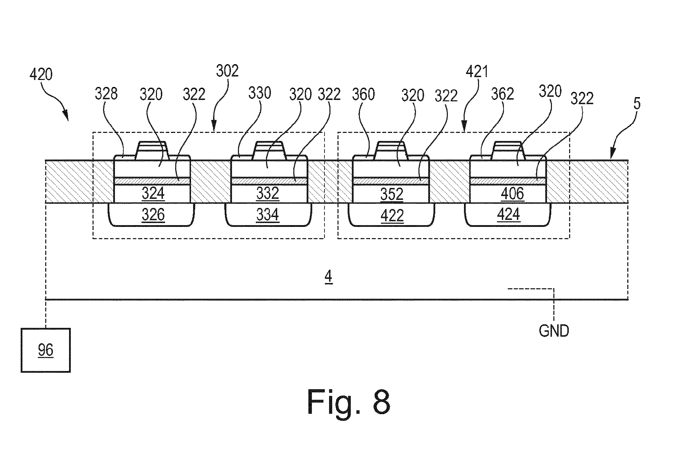

La figure 8 représente un circuit 420 réalisé en technologie FDSOI 20nm et apte à être utilisé en lieu et place des circuits 300 ou 400. Ce circuit 420 est identique au circuit 300, sauf que l'isolation électrique des grilles arrières des transistors de la cellule d'horloge 304 de celle des transistors de la cellule logique 302 est assurée par les caissons respectifs de ces transistors. À cet effet :
- le caisson profondément enterré 370 est omis,
- la cellule 402 est remplacée par une cellule 421, identique à la cellule 402 sauf que les caissons 356 et 358 sont remplacés, respectivement, par des caissons 422 et 424, qui présentent tous deux des dopages de type n, opposés au dopage du substrat 4. Ces caissons 422 et 424 forment ainsi, avec le substrat 4, des jonctions p-n aptes à être polarisées en sens inverse lors du fonctionnement du circuit 420.

En outre, le circuit 96 est alors configuré pour appliquer un potentiel égal à GND sur les caissons qui présentent un même type de dopage que le substrat 4, à savoir, ici, appliquer un potentiel V_{P_BP_L} = 0V sur le caisson 326.

Les plans de masse 324 et 332 peuvent être permutés. Dans ce cas, les caissons 326 et 334 sont également permutés. Il en va de même pour les plans de masse 352 et 354 et les caissons 356 et 358. Les plans de masse 352, 406 et le caisson 404 peuvent présenter un dopage différent.

Les potentiels électriques appliqués sur les différents caissons peuvent prendre des valeurs différentes de celles décrites en référence à l'étape 102.

Les différences de potentiel de grille arrière V_{P_FBB_L} et V_{N_FBB_L} peuvent présenter des valeurs négatives (« reverse back biasing » en langue anglaise). Dans ce cas, les valeurs de ces différences de potentiel de grille arrière sont choisies de façon à éviter la formation de diodes passantes entre des régions de dopage opposé des cellules 6 et 8, car cela aurait pour effet de causer des courants de fuite dans le circuit 2. Pour simplifier la description, la notation « FBB » est conservée en indice des symboles V_{P_FBB_L} et V_{N_FBB_L}.

## Revendications

1. Procédé de commande d'un circuit intégré, ce procédé comportant :
- la fourniture (100) d'un circuit intégré (2) comprenant :
• une pluralité de cellules logiques (6), incluant chacune au moins un premier (20) et un second (22) transistors à effet de champ, respectivement pMOS et nMOS ;
• une cellule d'arbre d'horloge (8), incluant au moins un troisième (60) et un quatrième (62) transistors à effet de champ, respectivement, pMOS et nMOS, cette cellule d'arbre d'horloge étant apte à fournir un signal d'horloge aux cellules logiques ;
• un substrat (4) semi-conducteur, sur lequel sont réalisées les cellules logiques et la cellule d'arbre d'horloge ;
• chacun desdits transistors comportant :
○ une source, un drain et une région de canal de conduction,
○ un empilement de grille, situé à l'aplomb de la région de canal de conduction,
○ une grille arrière, située en regard de la grille, de l'autre côté du canal de conduction,
• la différence de potentiel de grille arrière d'un desdits transistors étant définie comme la différence entre :
○ le potentiel électrique appliqué sur la source (V_{DD_L}, V_{DD_CLK}) de ce transistor moins le potentiel électrique appliqué sur la grille arrière (V_{P_BP_L}, V_{P_BP_CLK}) de ce transistor, lorsque ce transistor est de type pMOS ; et
○ le potentiel électrique appliqué sur la grille arrière (V_{N_BP_L}, V_{N_BP_CLK}) de ce transistor moins le potentiel électrique appliqué sur la source (V_{GND_L}, V_{GND_CLK}) de ce transistor, lorsque ce transistor est de type nMOS ;
- l'application (102) de première (V_{P_FBB_L}) et seconde (V_{N_FBB_L}) différences de potentiel électrique de grille arrière sur les, respectivement, premier et second transistors de mêmes cellules logiques ;
- l'application (104) d'une troisième différence de potentiel électrique (V_{P_FBB_CLK}) de grille arrière sur le troisième transistor, cette troisième différence de potentiel de grille arrière étant positive et présentant une valeur supérieure à la première différence de potentiel de grille arrière (V_{P_FBB_L}) appliquée au même moment, ou
- l'application d'une quatrième différence de potentiel électrique (V_{N_FBB_CLK}) de grille arrière sur le quatrième transistor, cette quatrième différence de potentiel de grille arrière étant positive et présentant une valeur supérieure à la seconde différence de potentiel de grille arrière (V_{N_FBB_L}) appliquée au même moment.

2. Procédé selon la revendication 1, dans lequel les première et seconde différences de potentiel présentant une valeur positive.

3. Procédé selon la revendication 1 ou 2, dans lequel les troisième et quatrième différences de potentiel de grille arrière sont appliquées simultanément sur, respectivement, les troisième et quatrième transistors.

4. Procédé selon l'une quelconque des revendications précédentes, comportant la fourniture (100) du circuit intégré incluant un caisson semi-conducteur ou un caisson semi-conducteur profondément enterré, de dopage opposé au dopage du substrat, interposé entre la grille arrière du troisième transistor et le substrat, ce caisson semi-conducteur ou ce caisson semi-conducteur profondément enterré étant électriquement isolé de la grille arrière du premier transistor par l'intermédiaire d'une jonction p-n apte à être polarisée en sens inverse lors du fonctionnement du circuit intégré.

5. Procédé selon les revendications 3 et 4, comportant la fourniture (100) du circuit intégré dans lequel un caisson semi-conducteur ou un caisson semi-conducteur profondément enterré, est en outre interposé entre la grille arrière du quatrième transistor et le substrat, ce caisson semi-conducteur ou ce caisson semi-conducteur profondément enterré étant électriquement isolé de la grille arrière du second transistor par l'intermédiaire d'une jonction p-n apte à être polarisée en sens inverse lors du fonctionnement du circuit intégré.

6. Procédé selon la revendication 3, comportant :
- la fourniture (100) du circuit intégré (2) :
• dans lequel les premier, second, troisième et quatrième transistors sont des transistors de technologie « bulk », dans lequel le canal de conduction n'est pas électriquement isolé de la grille arrière par une couche en matériau électriquement isolant, les premier et troisième transistors comportant respectivement des premier et troisième caissons semi-conducteurs présentant un dopage de type n, les second et quatrième transistors comportant respectivement des second et quatrième caissons semi-conducteurs présentant un dopage de type p, chacun de ces caissons formant une grille arrière dudit transistor ;
• comportant en outre des premier (50) et second (90) caissons profondément enterrés, présentant chacun un dopage de type opposé au dopage du substrat, le premier caisson profondément enterré s'étendant sous les premier et second caissons semi-conducteurs de manière à isoler ces caissons du substrat, le second caisson profondément enterré s'étendant sous les troisième et quatrième caissons de manière à isoler ces caissons du substrat, ces premier et second caissons profondément enterrés n'étant pas directement électriquement connectés entre eux ;
- l'application (104) simultanée des troisième et quatrième différences de potentiel de grille arrière.

7. Procédé selon la revendication 3, dans lequel le procédé comporte :
- la fourniture (100) du circuit intégré (400) dans lequel :
• les premier, second, troisième et quatrième transistors sont des transistors de technologie FDSOI et comportent chacun un plan de masse semi-conducteur électriquement isolé du canal de conduction par une couche en matériau électriquement isolant, ce plan de masse formant la grille arrière de ce transistor ;
• chacun des premier et second transistors comporte un caisson semi-conducteur, placé sous et à l'aplomb du plan de masse de ce transistor ;
• la cellule d'horloge comporte en outre un troisième caisson semi-conducteur (404) s'étendant sous et à l'aplomb des plans de masse des troisième et quatrième transistors, ces plans de masse et le troisième caisson présentant un même type de dopage que le substrat ;
• le circuit comporte en outre un caisson semi-conducteur profondément enterré, de dopage opposé au dopage du substrat, s'étendant sous le troisième caisson, en contact direct avec ce troisième caisson ;
- l'application d'un même potentiel électrique sur les plans de masse des troisième et quatrième transistors.

8. Procédé selon la revendication 1 ou 2, comportant : la fourniture (100) du circuit intégré (300) dans lequel :
• les premier, second, troisième et quatrième transistors sont des transistors de technologie FDSOI et comportent chacun un plan de masse semi-conducteur électriquement isolé du canal de conduction par une couche en matériau électriquement isolant, ce plan de masse formant la grille arrière de ce transistor ;
• les premier et troisième transistors comportent respectivement des premier et troisième caissons semi-conducteurs présentant un dopage d'un premier type et s'étendant respectivement sous des grilles arrière de ces premier et troisième transistors ;
• les second et quatrième transistors comportent, respectivement, des second et quatrième caissons semi-conducteurs présentant un dopage d'un second type, opposé au premier type, et s'étendant respectivement sous des grilles arrière de ces second et quatrième transistors ;
• le circuit comporte en outre un caisson semi-conducteur profondément enterré (370), de dopage opposé au dopage du substrat, s'étendant sous les caissons en contact direct avec ces caissons ;
- l'application (104) de seulement la troisième ou la quatrième différence de potentiel de grille arrière.

9. Procédé selon la revendication 1, comportant :
- la fourniture (100) du circuit intégré (220) dans lequel les premier, second, troisième et quatrième transistors sont des transistors de technologie « bulk », dans lequel le canal de conduction n'est pas électriquement isolé de la grille arrière par une couche en matériau électriquement isolant, les premier et troisième transistors comportant respectivement des premier et troisième caissons semi-conducteurs présentant un dopage de type n, les second et quatrième transistors comportant respectivement des second et quatrième caissons semi-conducteurs présentant un dopage de type p, ces caissons formant les grilles arrière respectives desdits transistors et étant en contact électrique direct avec le substrat ;
- l'application (104) de la troisième différence de potentiel de grille arrière mais pas de la quatrième différence de potentiel de grille arrière.

10. Procédé selon la revendication 1 ou 2, comportant :
- la fourniture (100) du circuit intégré (200) :
• dans lequel les premier, second, troisième et quatrième transistors sont des transistors de technologie « bulk », dans lequel le canal de conduction n'est pas électriquement isolé de la grille arrière par une couche en matériau électriquement isolant, les premier et troisième transistors comportant respectivement des premier et troisième caissons semi-conducteurs présentant un dopage de type n, les second et quatrième transistors comportant respectivement des second et quatrième caissons semi-conducteurs présentant un dopage de type p ;
• comportant un caisson semi-conducteur profondément enterré, présentant un dopage de type opposé au dopage du substrat, ce caisson profondément enterré s'étendant à la fois sous les premier, second, troisième et quatrième caissons semi-conducteurs de manière à isoler ces caissons du substrat ;
- l'application (104) de la quatrième différence de potentiel de grille arrière mais pas de la troisième différence de potentiel de grille arrière.
